Europäisches Patentamt

European Patent Office

Office européen des brevets

(11) Numéro de publication: **0 189 744**
**A1**

## (12) DEMANDE DE BREVET EUROPEEN

(21) Numéro de dépôt: 86100023.0

(22) Date de dépôt: 02.01.86

(51) Int. Cl.⁴: **H 03 K 23/54**

(30) Priorité: 08.01.85 FR 8500193

(43) Date de publication de la demande:
06.08.86 Bulletin 86/32

(84) Etats contractants désignés:
DE FR GB IT NL

(71) Demandeur: LIGNES TELEGRAPHIQUES ET
TELEPHONIQUES L.T.T.
1, rue Charles Bourseul
F-78702 Conflans-Ste-Honorine(FR)

(72) Inventeur: Borgne, Eric
La Chapelle Christ
F-22560 Trebeurden(FR)

(72) Inventeur: Niquel, Maurice
Ru de de Karent Ar Bigorned
F-22700 Perros Guirec(FR)

(74) Mandataire: Weinmiller, Jürgen et al,
Zeppelinstrasse 63
D-8000 München 80(DE)

(54) Diviseur de fréquences.

(57) L'invention concerne un diviseur de fréquences comportant un nombre déterminé (n) de bistables (B1 à Bn) dans lequel la sortie Q de chaque bistable (B1 à Bn-1) est connectée à l'entrée (D) du bistable (B2 à Bn) de rang suivant, la sortie (Qn) du dernier bistable (Bn) étant connectée à l'entrée (D1) du premier bistable (B1). La sortie (Qn) du dernier bistable (Bn) est connectée par une ligne à retard (τ) à l'entrée de forçage (R) du premier bistable (B1).

Fig.18

EP 0 189 744 A1

# DIVISEUR DE FREQUENCES

L'invention concerne un diviseur de fréquences réalisable notamment à l'aide d'une ou plusieurs bascules bistables.

Les diviseurs de fréquences sont couramment réalisés dans la technique par les chaînes de bascules bistables agencées en compteurs binaires. Pour obtenir un rapport de division particulier, on sélectionne les sorties appropriées d'un compteur et on les combine à l'aide de portes logiques.

Cependant, une telle conception conduit souvent à avoir un nombre de portes important.

L'objet de l'invention est de simplifier la réalisation de tels compteurs en diminuant le nombre de circuits.

L'invention concerne donc un diviseur de fréquences recevant sur une entrée des impulsions d'horloge de période déterminée, fournissant sur une sortie des impulsions dont la fréquence est un dans un rapport déterminé à celle des impulsions d'horloge, un étage d'entrée du diviseur de fréquence comprenant au moins une bascule bistable à fonctionnement synchronisé sur les impulsions d'horloge et étant munie d'une entrée de forçage à un niveau logique déterminé, caractérisé en ce qu'il comporte une ligne à retard connectant la sortie du diviseur de fréquence à l'entrée de forçage de façon à inhiber au moins une impulsion d'horloge susceptible de commander le basculement de la bascule bistable.

Les différents objets et caractéristiques de l'invention seront détaillés dans la description qui va suivre faite en se reportant aux figures annexées qui représentent :

- les figures 1 et 2, un diviseur de fréquences par deux de l'art connu ;

- les figures 3 et 4, un diviseur de fréquences par trois de l'art connu ;

- les figures 5 et 6, un diviseur de fréquences par trois selon l'invention ;

- les figures 7 et 8, un diviseur de fréquences par quatre selon l'art connu ;

    - les figures 9, 10 et 11, un diviseur de fréquences par cinq ou par six selon l'invention ;

    - les figures 12 et 13, un diviseur de fréquences par six selon l'art connu ;

    - les figures 14 à 17, un diviseur de fréquences par sept, par huit ou par neuf selon l'invention ;

    - les figures 18 à 20, un diviseur de fréquences dont le rapport est compris entre 2n et 3n ;

    - les figures 21 à 25, des variantes de réalisation des diviseurs de fréquences selon l'invention.

Dans la description qui va suivre, les différents diviseurs de fréquences comporteront une ou plusieurs bascules bistables de type D. Une telle bascule possède une entrée d'horloge H, une entrée D de commande synchronisée par l'entrée d'horloge H, une entrée R de forçage à zéro et deux sorties Q et $\overline{Q}$. La constitution de ce type de bascule est connue dans la technique et ne sera donc pas décrite.

Dans ce qui suit, le basculement d'un bistable D sera provoqué sur le flanc montant d'une impulsion d'horloge H reçu sur son entrée d'horloge H et le bistable prendra la position 0 ou 1 d'un niveau logique 0 ou 1 appliqué sur son entrée D.

Le fonctionnement de tels circuits serait similaire si on considérait des basculements sur les flancs descendant des impulsions d'horloge. De même en inversant la logique on pourrait utiliser une entrée de forçage à un du bistable D au lieu d'une entrée de forçage à zéro.

Enfin, on a considéré l'utilisation de bistable de type D mais l'invention serait également applicable en utilisant des bistables d'un autre type tels les bistables de type JK.

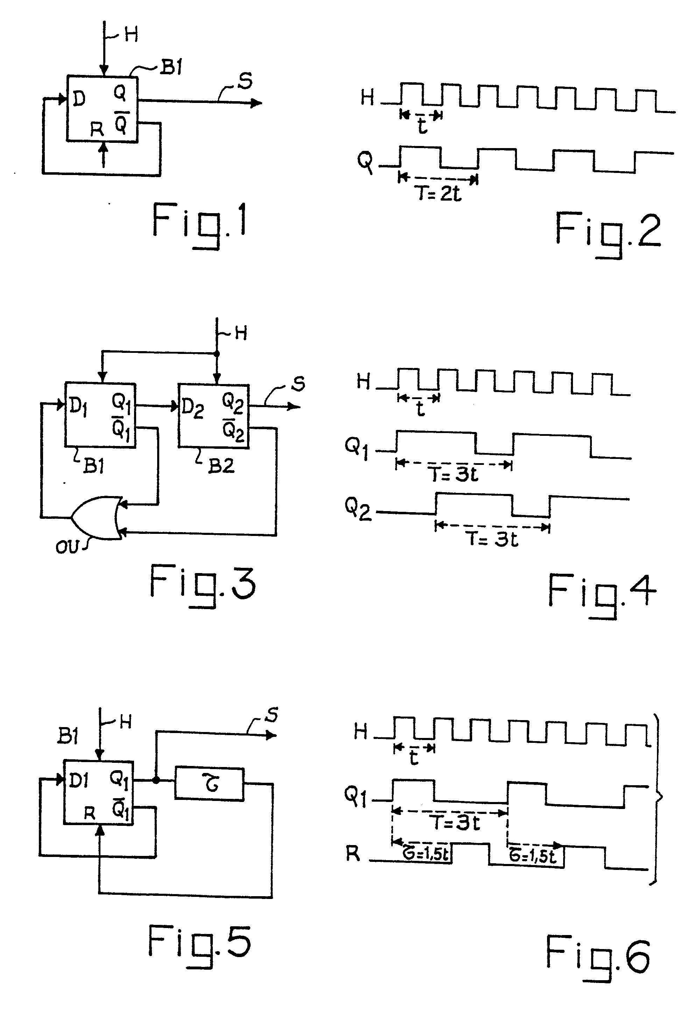

En se reportant aux figures 1 et 2 on va décrire un diviseur de fréquences par deux connu dans la technique.

Ce diviseur comporte un bistable B1 de type D tel que décrit précédemment. La sortie $\overline{Q}$ du bistable B1 est connectée à

l'entrée D.

Le bistable B1 reçoit sur son entrée d'horloge des signaux d'horloge H, dont la période est t, tels que représentés en figure 2.

Si on considère le bistable B en position 0, il délivre sur sa sortie $\bar{Q}$ un signal de niveau 1 et le transmet à l'entrée D. Sur le flanc montant d'une impulsion d'horloge H, le bistable B bascule en position 1. Le bistable fournit un niveau logique 1 sur sa sortie Q et un niveau logique 0 sur sa sortie $\bar{Q}$. Un niveau logique 0 est donc appliqué à l'entrée D. Sur le flanc montant de l'impulsion suivante, le bistable B bascule en position 0 et ainsi de suite. Comme représenté en figure 2, la sortie Q du bistable B fournit sur la sortie S, un signal Q, tel que représenté en figure 2, dont la période T est deux fois celle du signal d'horloge. On a donc bien un diviseur de fréquence par deux.

Les figures 3 et 4 concernent un diviseur de fréquences par trois connu dans la technique. Il comporte deux bistables B1 et B2 de type D et une porte logique de type OU à deux entrées.

La sortie Q1 du bistable B1 est connectée à l'entrée D2 du bistable B2. La sortie Q2 du bistable B2 est connectée vers la sortie S du diviseur. Les sorties $\overline{Q1}$ et $\overline{Q2}$ des bistables B1 et B2 sont connectées aux entrées de la porte OU dont la sortie est connectée à l'entrée D1 du bistable B1.

Lorsque l'un ou l'autre des bistables B1 ou B2 est en position 0 et fournit un signal de niveau logique 1 sur sa sortie $\overline{Q1}$ ou $\overline{Q2}$, la porte OU fournit un signal de niveau logique 1 sur l'entrée D1 du bistable B1. Sur le flanc montant d'une impulsion d'horloge H, le bistable B1 bascule en position 1 (s'il ne l'était pas déjà). Le bistable B1 fournit un signal de niveau 1 sur sa sortie Q1. Si le bistable est en position 0 à ce moment là, sur le flanc montant de l'impulsion d'horloge suivante, il bascule en position 1. Les deux bistables se trouvent alors en position 1. Ils fournissent chacun un signal de niveau 0 sur leur sortie $\overline{Q1}$, $\overline{Q2}$. La porte OU fournit un signal de niveau 0 sur l'entrée D1, ce qui prépare le basculement du bistable B1 en position 0. Sur le flanc montant de l'impulsion d'horloge

suivante le bistable Bl bascule en position 0. Le fonctionnement se poursuit comme celà est illustré par le diagramme des temps de la figure 4.

Sur ce diagramme il apparaît que la période du signal Q2 fournit sur la sortie S a pour valeur T = 3t. La figure 3 représente donc bien un diviseur de fréquences par trois.

Cependant, ce diviseur a nécessité deux bascules bistables et une porte OU.

En se reportant aux figures 5 et 6, on va donc décrire un diviseur de fréquences par trois de réalisation plus simple. Ce diviseur ne nécessite qu'une bascule bistable Bl de type D et une ligne à retard $\tau$ connectant la sortie Q1 du bistable à l'entrée R de forçage à zéro.

La durée de la période du signal d'horloge ayant toujours pour valeur t, la durée du retard introduit par la ligne à retard $\tau$ est pris égal à $\tau = 1,5t$.

Le bistable Bl étant en position 0, il fournit un signal de niveau 1 sur sa sortie $\overline{Q1}$ vers l'entrée D1 du bistable. Sur le flanc montant d'une impulsions d'horloge H, le bistable Bl bascule en position 1 et fournit un signal de niveau 1 sur sa sortie Q1 et un signal de niveau 0 sur sa sortie $\overline{Q1}$.

Sur le flanc montant de l'impulsion d'horloge suivante, l'entrée D1 recevant un signal de niveau logique 0, le bistable Bl bascule en position 0. Il fournit un signal de niveau logique 1 sur l'entrée D1.

Comme celà est représenté sur le diagramme des temps de la figure 6, au bout d'un temps égal à $\tau = 1,5t$ à compter du précédent basculement en position 1 du bistable, le signal de niveau logique 1, fourni par la sortie Q1, est transmis à l'entrée R du bistable Bl. Celui-ci est en position 0 et est maintenu dans cette position pendant tout le temps (durée d'une période t) que l'entrée R est au niveau logique 1. Dans ces conditions, le flanc montant de l'impulsion d'horloge suivante est inefficace et ne peut pas faire basculer le bistable Bl en position 1 bien que l'entrée D1 soit au niveau logique 1.

Lorsque le signal de niveau logique 1, fourni par la ligne à retard $\tau$ sur l'entrée R, cesse le bistabe B1 peut à nouveau basculer en position 1 sur le flanc montant de l'impulsion d'horloge suivante.

Comme on peut le voir sur la figure 6, la période du signal Q1 fourni sur la sortie S a pour valeur T = 3t. Le circuit de la figure 5 se comporte donc bien en diviseur de fréquences par trois.

Dans l'exemple qui vient d'être décrit, la valeur du retard apporté par la ligne à retard $\tau$ était de 1,5t. Néanmoins, il est à souligner que la valeur de cette ligne à retard ne nécessite pas une grande précision. En effet, pour que le diviseur de fréquences fonctionne comme cela vient d'être décrit, il suffit, qu'en théorie, le retard $\tau$ soit compris entre t et 2t, ce qui explique la valeur de 1,5t que nous avons choisie.

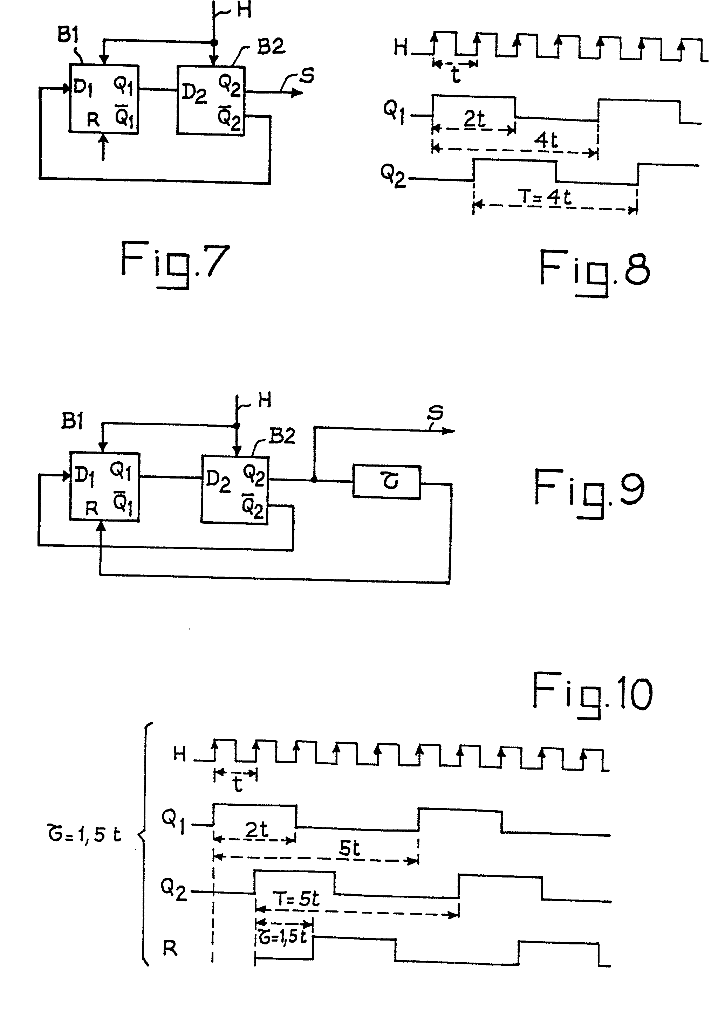

En se reportant aux figures 7 et 8, on va maintenant décrire un diviseur de fréquences par quatre conçu selon les techniques connues.

Le diviseur est constitué de deux bistables B1 et B2 de type D. La sortie Q1 du bistable B1 est connectée à l'entrée D2 du bistable B2. La sortie $\overline{Q2}$ du bistable B2 est connectée à l'entrée D1 du bistable B1 et la sortie S du diviseur de fréquences est connectée à la sortie Q2 du bistable B2.

Le bistable B1 est mis en position 1 sur le flanc montant d'une impulsion d'horloge H lorsque le bistable B2 est en postion 0. Inversement, il est mis en position 0 lorsque le bistable B2 est en position 1.

Le bistable B2 est mis en position 1 ou 0 selon que le bistable B1 est en position 1 ou 0 respectivement, sur le flanc montant de l'impulsion d'horloge H qui suit la mise dans ladite position du bistable B1. Les basculements successifs des bistables B1 et B2 se suivent donc décalés de la durée d'une période t du signal d'horloge H.

Comme représenté en figure 8, la période du signal Q2 fourni sur la sortie S a pour valeur T = 4t et le circuit de la figure 7 est bien un diviseur de fréquences par quatre.

En se reportant aux figures 9, 10 et 11, on va maintenant décrire un diviseur de fréquences selon l'invention, dérivé du diviseur précédent et permettant d'obtenir des rapports de division par cinq et par six.

Le circuit de la figure 9 comporte des bistables B1 et B2 de type D agencés comme ceux de la figure 7, et une ligne à retard connectant la sortie Q2 du bistable B2 à l'entrée R de forçage à zéro du bistable B1.

On considère tout d'abord que la valeur du retard $\tau$ apporté par la ligne à retard est compris entre t et 2t. Par exemple, $\tau$ a pour valeur 1,5t.

Les deux bistables étant en position 0, le bistable B1 reçoit un signal de niveau 1 sur son entrée D1. Il bascule en position 1 sur le flanc montant d'une impulsion d'horloge H. Le basculement du bistable B2 s'effectue donc sur le flanc montant de l'impulsion d'horloge suivante. Le bistable B2 fournit un signal Q2 sur la sortie S ainsi qu'à la ligne à retard.

La sortie $\overline{Q2}$ est au niveau logique 0 et l'entrée D1 du bistable B1 reçoit ce signal. Le bistable B1 bascule en position 0 sur le flanc montant de l'impulsion d'horloge suivante et commande ensuite le basculement du bistable B2 en position 0.

Au terme d'un temps $\tau$ = 1,5t à compter du début du signal Q2, l'entrée R de forçage à zéro du bistable B1 reçoit un signal de niveau logique 1 et celà durant un temps égal à 2t. Ce signal interdit le retour en position 1 du bistable B1 et inhibe de ce fait les impulsions d'horloge qui se présentent. Lorsque le signal de niveau 1 sur l'entrée R disparaît, le bistable B1 peut basculer en position 1 et le fonctionnement se poursuit comme décrit précédemment.

Le diagramme des temps de la figure 10 fait apparaître qu'un tel diviseur de fréquences fournit sur sa sortie S, un signal Q2 de période T = 5t et possède donc un rapport de division de cinq.

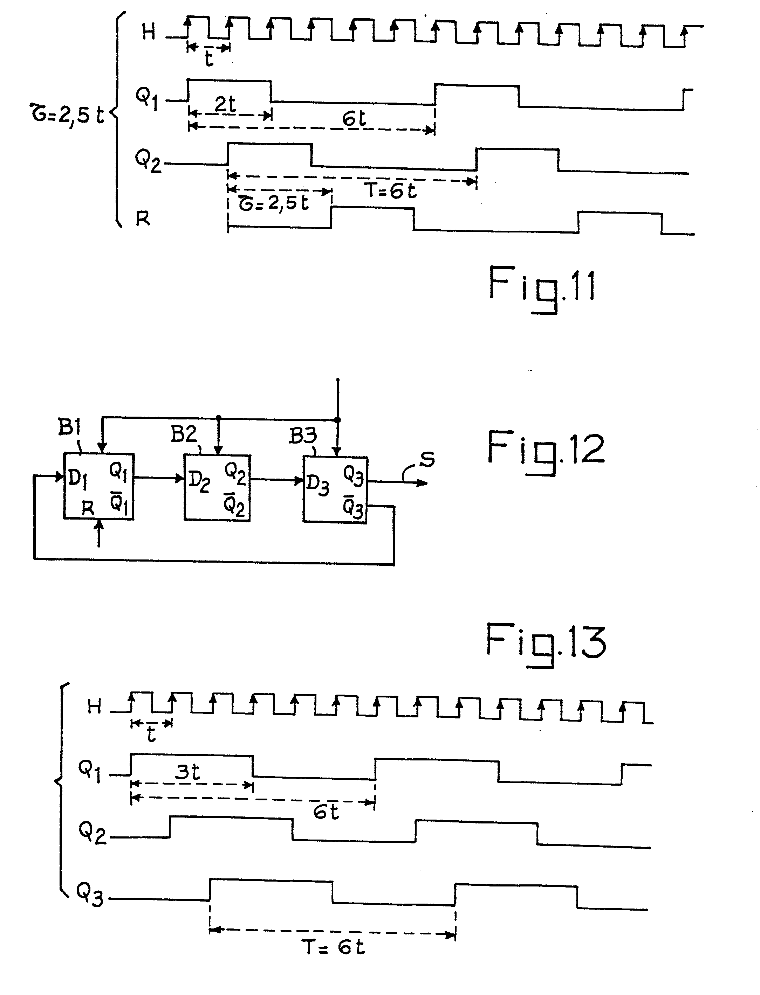

Si on considère maintenant, pour le même circuit de la figure 9, que le temps de retard $\tau$ apporté par la ligne à retard est compris entre 2t et 3t ; qu'il a, par exemple, pour valeur 2,5t, le fonctionnement du diviseur de fréquences est alors illustré par le diagramme de temps de la figure 11.

Le signal appliqué sur l'entrée R du bistable B1 inhibe alors, en raison du retard $\tau$ = 2,5 t, deux impulsions d'horloge sur B1, mais avec un retard supplémentaire t par rapport à la figure 10.

Dans ces conditions, la période du signal Q2 appliqué à la sortie S a pour valeur T = 6t et le diviseur de fréquences constitue un diviseur par six.

On voit donc qu'à partir d'un diviseur par quatre, en utilisant une ligne à retard $\tau$ on constitue au choix un diviseur par cinq ou par six.

En se reportant aux figures 12 et 13 on va maintenant décrire un diviseur de fréquences par six à partir duquel sera dérivé un diviseur de fréquences permettant d'obtenir selon l'invention d'autres rapports de division.

Le diviseur de la figure 12 comporte trois bistables B1, B2, B3 de type D et agencé de manière similaire à celui de la figure 7.

Comme représenté sur le diagramme des temps de la figure 13, les bistables B1, B2 et B3 basculent successivement chacun sur un flanc montant d'une impulsion d'horloge. Chaque bistable reste ainsi dans une position 1 ou 0 pendant un temps égal à trois périodes de signaux d'horloge 3t. La période du signal Q3 fourni à la sortie S du diviseur de fréquence est donc T = 6t. Le diviseur de fréquences est bien un diviseur par six.

Selon l'invention, on prévoit une ligne à retard $\tau$ connectant la sortie Q3 du bistable B3 à l'entrée R de forçage à zéro du bistable B1.

Selon un premier exemple de réalisation la valeur du retard apportée par la ligne à retard $\tau$ a une valeur comprise entre t et 2t, tel que $\tau$ = 1,5t.

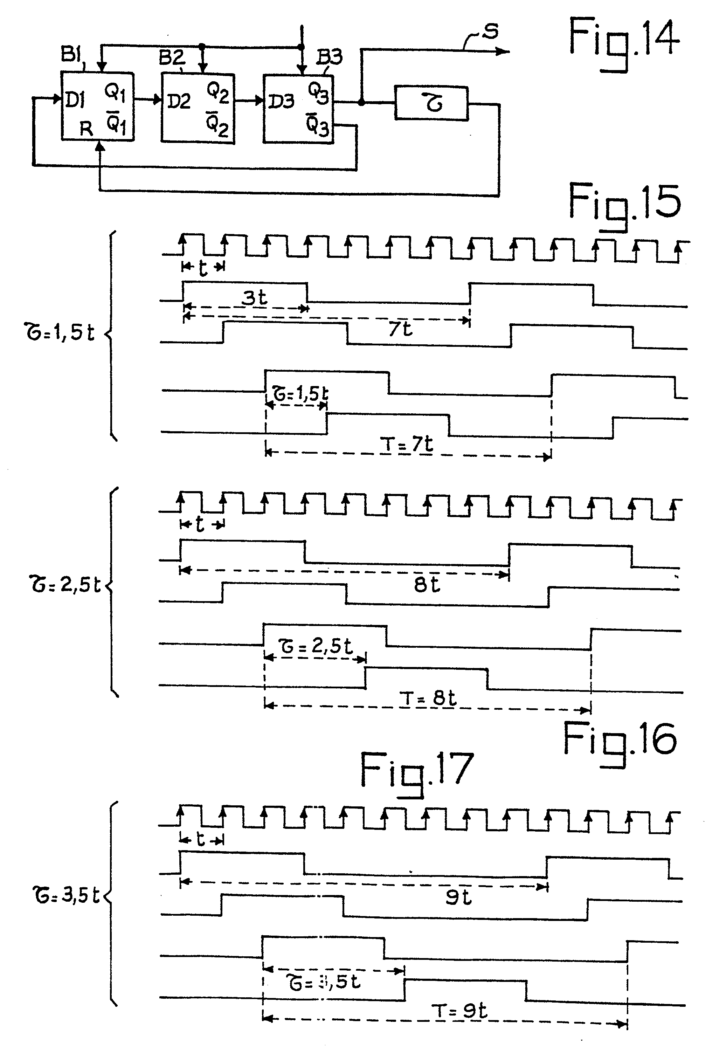

Le fonctionnement du diviseur est alors illustré par le diagramme des temps de la figure 15. Sur cette figure, on voit que la ligne à retard a pour effet de retransmettre, avec un retard égal à 1,5t, sur l'entrée R, les signaux Q3 du bistable B3. Chaque bistable B1, B2, B3 reste en position 1 pendant un temps égal à 3t. Le signal sur l'entrée R a donc pour durée 3t et inhibe l'effet de l'impulsion d'horloge qui suit la remise à zéro du bistable B3. Le bistable B1 ne peut donc revenir en position 1 qu'après une période de 7t.

Le signal Q3 fourni sur la sortie S du diviseur de fréquence a donc pour période T = 7t et le diviseur est un diviseur par sept.

Selon un deuxième exemple de réalisation la valeur du retard apporté par la ligne à retard $\tau$ a une valeur comprise entre 2t et 3t, tel que $\tau$ = 2,5t.

Le fonctionnement correspond à ce cas est illustré par la figure 16. Comme on peut le voir sur la figure, le signal sur l'entrée inhibe les deux impulsions d'horloge qui suivent la remise à zéro du bistable B3. Dans ces conditions, la période du signal Q3 sur la sortie S a pour valeur T = 7t. Le diviseur de fréquences est un diviseur par sept.

Enfin, la valeur du retard apporté par la ligne à retard peut avoir une valeur comprise entre 3t et 4t, par exemple 3,5t.

Le fonctionnement du diviseur de fréquences est alors illustré par le diagramme des temps de la figure 17 et la description de son fonctionnement est similaire à celle qui précède avec la différence que le signal sur l'entrée R inhibe les trois impulsions d'horloge qui suivent le basculement à zéro du bistable B3.

La période du signal Q3, fourni sur la sortie S, a pour valeur T = 9t. Le diviseur de fréquence est un diviseur par neuf.

On voit donc qu'à partir du diviseur par six de la figure 12, selon la valeur de la ligne à retard $\tau$ (figure 14), on a réalisé en diviseur de fréquences par sept, par huit ou par neuf.

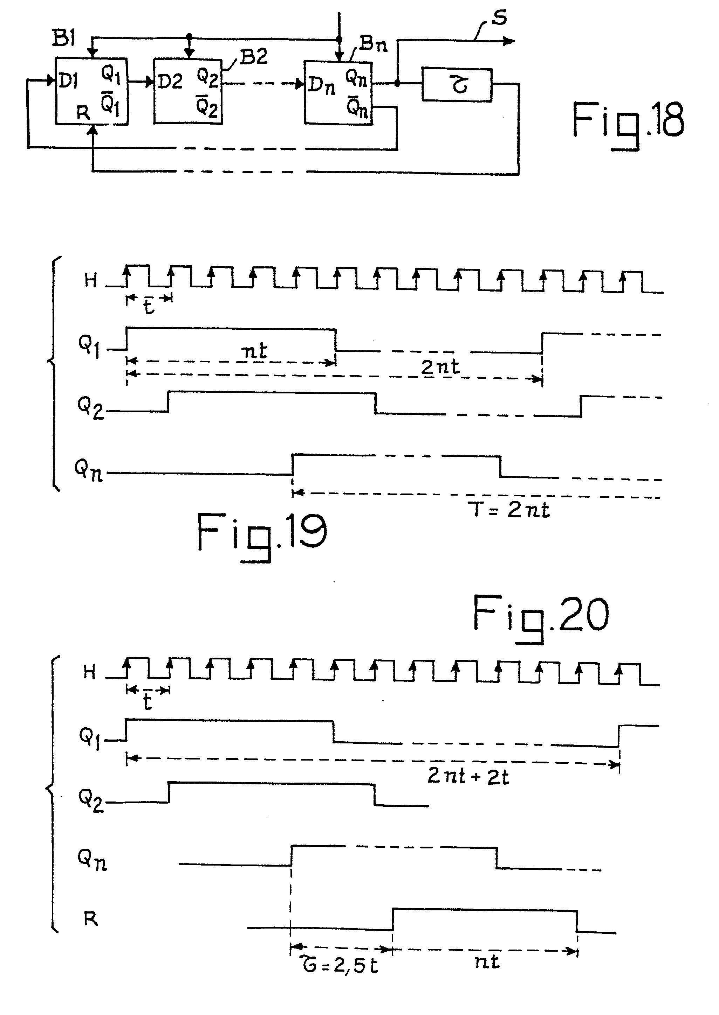

En généralisant et en portant le nombre de bistables du diviseur de fréquences à n, on obtient un circuit, tel que représenté en figure 18, comportant n bistables B1 à Bn configurés en diviseur par 2n.

En l'absence de ligne à retard $\tau$, la sortie Qn du bistable Bn n'étant pas connectée à l'entrée R du bistable R1, le fonctionnement

obtenu est celui représenté par le diagramme des temps de la figure 19.

Le basculement en position 0 ou 1 d'un bistable de rang déterminé Bl par exemple commande le basculement dans la même position 0 ou 1 du bistable de rang suivant, B2 selon l'exemple pris, lors du flanc montant de l'impulsion d'horloge suivante. Chaque bistable reste ainsi dans un position 0 ou 1 durant un temps nt. La période du signal Qn, fourni à la sortie S, a donc pour période $T = 2nt$. Le diviseur de fréquences possède un rapport de division de $2n$.

Conformément à l'invention, on connecte une ligne à retard $\tau$ entre la sortie Qn du bistable Bn et l'entrée R du bistable Bl comme celà est représenté sur la figure 18.

La ligne à retard est telle que le retard de transmission qu'elle apporte répond à la condition

$$at < \tau < (a + 1)t$$

où : t est la période des impulsions d'horloge et a est un nombre tel que $1 \leqslant a \leqslant n$.

Pour chaque valeur de a, on obtient un diviseur de fréquences dont le rapport de division est égal à $2n + a$.

A partir d'un diviseur de fréquences comportant n bistables on peut donc obtenir, selon la valeur de $\tau$, des diviseurs de fréquences dont le rapport de division est compris entre $2n$ et $3n$. C'est ainsi que, par exemple, pour un diviseur de fréquences comportant n bistables et pour une valeur $a = 2$ c'est-à-dire pour un retard $\tau$ répondant à la condition

$$2t < \tau < 3t$$

on a un rapport de division égal à $2n + 2$. Ce cas est illustré par le diagramme des temps de la figure 20. Sur ce diagramme on voit que le retard apporté à la retransmission du signal Qn à l'entrée R du bistable Bl a pour valeur $2,5t$. La période du signal Qn fourni sur la sortie S a donc pour valeur $T = 2nt + 2t$ et le rapport de division de fréquences est donc bien $2n + 2$.

On voit donc que le diviseur de fréquences de l'invention permet bien d'obtenir à partir d'un diviseur comportant un nombre déterminé de bistables, d'autres diviseurs de rapports de division différents.

Il est à noter que dans les exemples de réalisation qui précèdent, la sortie Qn du bistable de sortie Bn est connectée à l'entrée R du premier bistable B1 par la ligne à retard $\tau$. Cependant, selon une variante de réalisation de l'invention non représentée, il est possible au lieu d'effectuer la connexion qui vient d'être décrite, de connecter, à l'entrée R du premier bistable, la sortie de type Q de l'une quelconque des bistables à l'aide d'une ligne à retard $\tau$ de durée de retard approprié pour inhiber les impulsions d'horloge nécessaires.

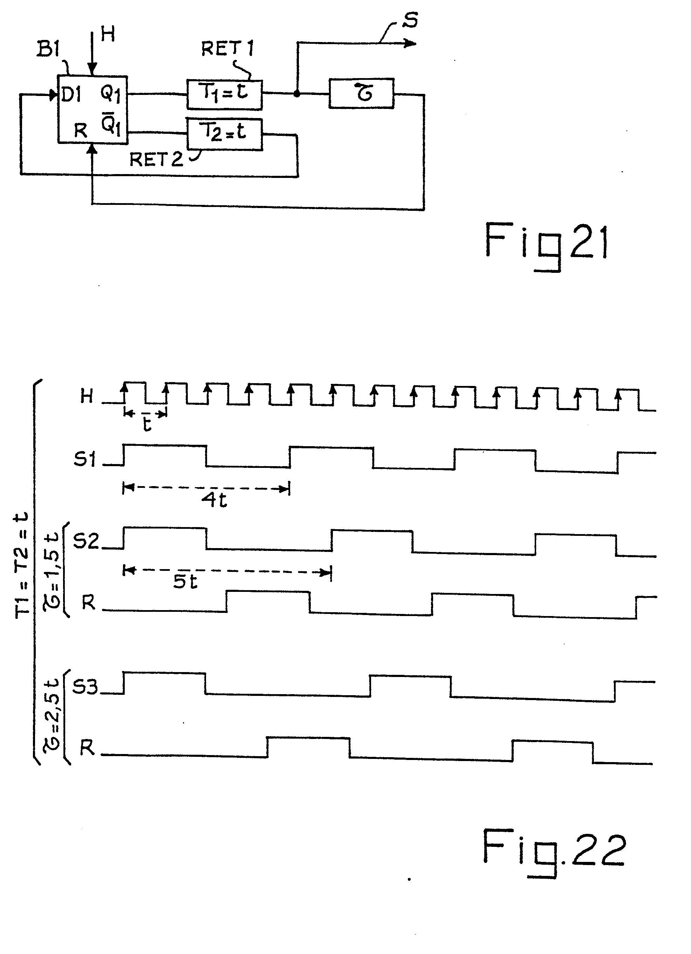

En se reportant aux figures 21 à 25, on va maintenant décrire une variante de réalisation ayant pour objet de mettre en évidence que l'invention concerne un diviseur de fréquences dont essentiellement le premier étage est une bascule bistable.

Par exemple, selon le diviseur de fréquences de la figure 21, la sortie Q1 du bistable B1 est connectée à une ligne à retard RET1 fournissant les signaux de sortie S du diviseur de fréquences. La ligne à retard RET1 est connectée à l'entrée de forçage R par une ligne à retard $\tau$. La sortie $\overline{Q1}$ est connectée à l'entrée D1 du bistable B1 par une autre ligne à retard RET2. Les valeurs des retards T1 et T2 apportées par les deux lignes à retard RET1 et RET2 sont égaux. Selon l'exemple de la figure 21 ces retards sont égaux à la période du signal d'horloge t.

En se reportant au diagramme des temps de la figure 22, on va maintenant décrire le fonctionnement du diviseur de fréquences de la figure 21.

On suppose tout d'abord que la sortie de la ligne à retard RET1 n'est pas connectée à l'entrée de forçage R du bistable. Lorsque le bistable est en position 0, et qu'il reçoit un signal de niveau logique 1 sur son entrée D1. Le bistable bascule en position 1 sur le flanc montant de la première impulsion d'horloge H qui se présente. Le bistable B1 fournit un signal de niveau logique 1 sur sa sortie S

comme cela est représenté sur la courbe S1 de la figure 22. Il fournit un signal de niveau logique 0 sur sa sortie $\overline{Q1}$. La retransmission de ce signal à l'entrée D1 est retardée d'un temps t. Le bistable B1 ne peut donc pas basculer en position 0 à la première impulsion d'horloge qui suit celle qui a provoquée le basculement précédent, mais basculera à la deuxième impulsion. Le bistable B1 reste donc en position 1 pendant un temps égal à 2t. La durée d'une période du signal S1 fournie sur la sortie S sera donc de 4t. Le diviseur de fréquences est un diviseur par quatre.

Si on considère maintenant que la sortie de la ligne à retard RET1 est connectée à l'entrée de forçage R du bistable B1 par une ligne à retard $\tau$ apportant un retard $\tau$ de valeur 1,5t, on voit en se reportant aux courbes référencées $\tau$ = 1,5t de la figure 22, qu'un signal Q2 fourni sur la sortie S est retransmis à l'entrée R de forçage à zéro avec un retard de 2,5t. Ce retard correspond aux retards cumulés des lignes à retard RET1 et $\tau$. La période du signal de sortie S2 prend pour valeur T = 5t. Le diviseur de fréquences est un diviseur par cinq.

Pour une valeur de retard de la ligne à retard $\tau$ égal à 2,5t, on obtient, comme représenté sur les courbes référencées $\tau$ = 2,5t, une période du signal S3 fourni sur la sortie S de T = 6t. On obtient dont un diviseur par six.

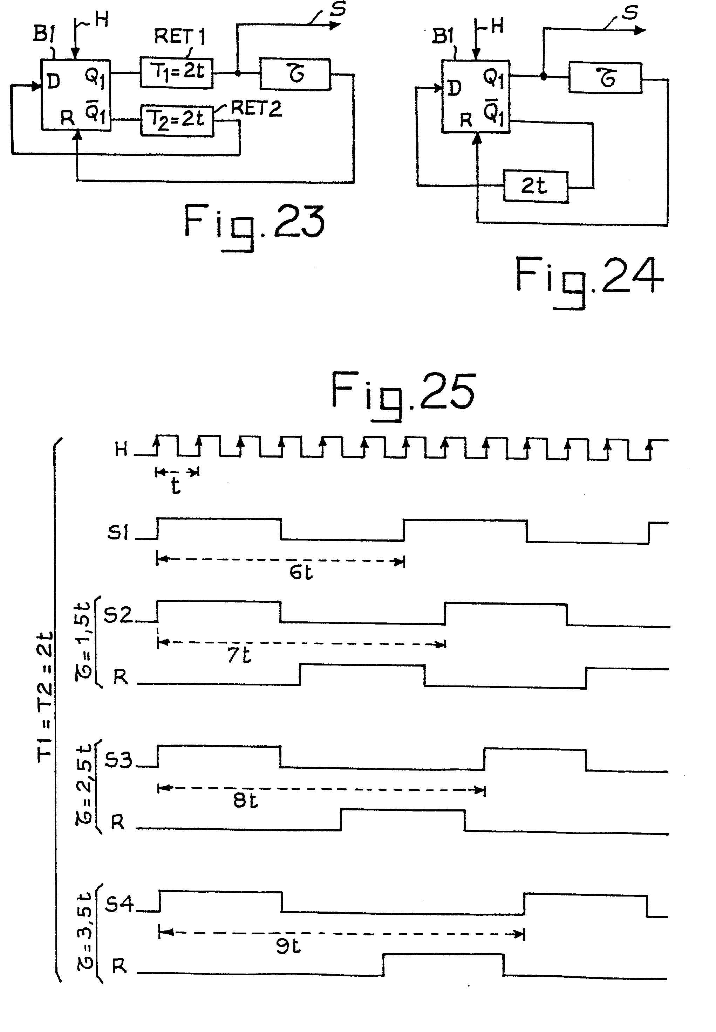

En généralisant cette variante de réalisation, on obtient un diviseur de fréquences tel que représenté en figure 23 dans lequel les retards des lignes à retard RET1 et RET2 ont pour valeur T1 = T2 = (m-1)t.

La ligne à retard $\tau$ est alors telle que le retard de transmission qu'elle apporte répond à la condition :

$$at < \tau < (a + 1)t$$

avec a nombre entier tel que :

$$1 \leqslant a \leqslant m$$

Pour chaque valeur de a, on obtient un diviseur de fréquences dont le rapport de division est 2m + a.

Les diagrammes des temps de la figure 25 illustrent le fonctionnement d'un tel oscillateur pour la valeur m = 3.

En l'absence de ligne à retard $\tau$, la période du signal S1 fourni sur la sortie est T = 2mt = 6t. Le rapport de division est six.

Avec une ligne à retard $\tau$ et avec a = 1, tel que $\tau$ = 1,5t, on obtient un signal de sortie S2 de période T = 7t tel que représenté par les courbes référencées $\tau$ = 1,5t de la figure 25. Le rapport de division du diviseur de fréquences est donc sept.

De même, avec une ligne à retard selon laquelle a = 2 et dont $\tau$ a, par exemple, pour valeur 2,5t, on a pour période du signal de sortie S3 : T = 8t, comme celà est représenté par les courbes $\tau$ = 2,5t de la figure 25. Le diviseur est un diviseur par huit.

Enfin, pour a = 3 et $\tau$ = 3,5t répondant toujours aux conditions indiquées précédemment, on obtient comme on peut le voir sur les courbes $\tau$ = 3,5t de la figure 25, un diviseur par neuf.

Il est bien évident que le diviseur de fréquences de la figure 23 peut être réalisé comme représenté figure 24. Dans ce mode de réalisation, la ligne à retard $\tau$ est telle qu'elle apporte un retard égal à la somme de ceux apportés par les lignes à retard RET1 et $\tau$ de la figure 23.

Le diviseur de fréquences de l'invention permet ainsi de porter le rapport de division de 2m à 3m et de choisir les rapports de division compris entre 2m et 3m.

REVENDICATIONS

1. Diviseur de fréquences recevant sur une entrée (4) des impulsions d'horloge de période (t) déterminée, fournissant sur une sortie (S) des impulsions dont la fréquence est un dans un rapport déterminé à celle des impulsions d'horloge, un étage d'entrée du diviseur de fréquence comprenant au moins une bascule bistable (B1) à fonctionnement synchronisé sur les impulsions d'horloge et étant munie d'une entrée de forçage à un niveau logique déterminé (R), caractérisé en ce qu'il comporte une ligne à retard ($\tau$) connectant la sortie (S) du diviseur de fréquence à l'entrée de forçage (R) de façon à inhiber au moins une impulsion d'horloge susceptible de commander le basculement de la bascule bistable (B1).

2. Diviseur de fréquences selon la revendication 1 délivrant des signaux de niveau logique 1, caractérisé en ce que l'entrée de forçage (R) de la bascule bistable (B1) est une entrée de forçage à zéro.

3. Diviseur de fréquences selon la revendication 1, caractérisé en ce que chaque impulsion de sortie à une durée (nt) égale à un multiple entier de la durée d'une période (t) d'horloge (H), et en ce que le retard apporté par la ligne à retard est compris entre la durée d'une période (t) d'horloge (H) et cette durée (t) augmentée de ladite durée (nt) de l'impulsion de sortie.

4. Diviseur de fréquences selon la revendication 1, comportant une série d'un nombre (n) déterminé de bascules bistables (B1 à Bn), caractérisé en ce que la ligne à retard ($\tau$) connecte la sortie de la dernière bascule bistable (Bn) à l'entrée de forçage (R) du premier bistable (B1), la durée du retard apporté par la ligne à retard est comprise entre la durée de la période d'horloge (t) et cette durée augmentée du produit du nombre de bistables (n) par cette durée.

5. Diviseur de fréquences selon la revendication 4, caractérisé en ce que les bascules bistables sont des bistables de type (D) possédant chacun une sortie (Q), une sortie ($\overline{Q}$), une entrée d'horloge (H), une entrée de commande synchronisée (D), une entrée de forçage à zéro (R), les entrées d'horloge (H) recevant chacune les impulsions d'horloge (H), la sortie (Q) de chaque bistable (B1 à Bn-1) étant connectée à l'entrée (D) du bistable (B2 à Bn) de rang suivant, la sortie ($\overline{Qn}$) du dernier bistable (Bn) étant connectée à l'entrée (D1) du premier bistable (B1) et la sortie (Qn) du dernier bistable (Bn) étant connectée par une ligne à retard ($\mathcal{T}$) à l'entrée de forçage (R) du premier bistable (B1).

6. Diviseur de fréquences selon la revendication 1, caractérisé en ce qu'il comporte une bascule bistable (B1) du type (D) possédant une entrée d'horloge (H), une entrée de commande synchronisée (D), une entrée de forçage à zéro (R), une sortie (Q) et une sortie ($\overline{Q}$), la sortie ($\overline{Q}$) étant connectée à l'entrée de commande synchronisée (D) par une première ligne à retard (RET2), la sortie (Q) étant connectée à l'entrée de forçage à zéro (R) par une deuxième ligne à retard (RET1) et par une troisième ligne à retard ($\mathcal{T}$), les valeurs des retards introduits par la première et la deuxième lignes à retard (RET1 et RET2) étant toutes deux multiples de la période (t) des impulsions d'horloge dans un rapport déterminé (m - 1) de façon qu'en l'absence de la troisième ligne à retard ($\mathcal{T}$) le rapport de division soit connu (m), le retard introduit par la troisième ligne à retard ($\mathcal{T}$) étant compris entre la durée d'une période (t) des impulsions d'horloge et cette durée augmentée du produit dudit rapport de division (m) par cette durée de période (t).

Fig.1

Fig.2

Fig.3

Fig.4

Fig.5

Fig.6

Fig.7

Fig.8

Fig.9

Fig.10

$G=2,5t$

H

$Q_1$

$2t$     $6t$

$Q_2$

$G=2,5t$     $T=6t$

R

## Fig.11

B1     B2     B3

$D_1$ $Q_1$  $D_2$ $Q_2$  $D_3$ $Q_3$  $S$

$R$ $\bar{Q}_1$  $\bar{Q}_2$  $\bar{Q}_3$

## Fig.12

## Fig.13

H

$Q_1$     $3t$     $6t$

$Q_2$

$Q_3$

$T=6t$

0189744

Fig.14

Fig.15

Fig.16

Fig.17

0189744

Fig.18

Fig.19

Fig.20

Fig.21

Fig.22

Fig.23

Fig.24

Fig.25

# 0189744

**RAPPORT DE RECHERCHE EUROPEENNE**

Numéro de la demande

EP  86 10 0023

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | PATENTS ABSTRACTS OF JAPAN, vol. 5, no. 171 (E-80) [843], 30 octobre 1981, page 17 E 80; & JP - A - 56 98 030 (NIPPON DENKI K.K.) 07-08-1981 * Figures; page E-80 843 * | 1-5 | H 03 K  23/54 |
| A | ELEKTRONIK, vol. 14, no. 10, octobre 1965, page 291-296; F. NEUMAYER: "Zählgeräte mit dynamischer Speicherung" * Figures 1a,1b; page 291, colonne de gauche, ligne 1 - colonne de droite, ligne 28 * | 1 | |
| A | US-A-3 200 340  (DUNNE) * Figures; colonne 2, ligne 65 - colonne 3, ligne 20; colonne 3, lignes 38-48 * | 1 | DOMAINES TECHNIQUES, RECHERCHES (Int. Cl.4) |
| A | DE-A-2 419 768  (LICENTIA) * En entier * | 1,2 | H 03 K |

Le présent rapport de recherche a été établi pour toutes les revendications

| Lieu de la recherche | Date d'achèvement de la recherche | Examinateur |
|---|---|---|
| LA HAYE | 09-04-1986 | FEUER F.S. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant